# EUROPEAN PATENT SPECIFICATION

(11) **EP 2 112 723 B1**
(45) Date of publication and mention of the grant of the patent: **16.04.2014**
(21) Application number: 09005731.6
(22) Date of filing: 23.04.2009
(51) Int. Cl.: H01R 13/66, H01R 43/02, H01R 13/658, H05K 3/32

(54) **Laser welding method**
Laserschweißverfahren
Procédé de soudage laser

(30) Priority: 24.04.2008 WO PCT/JP2008/057963; 04.03.2009 JP 2009050886
(43) Date of publication of application: 28.10.2009
(73) Proprietor: Iriso Electronics Co., Ltd., Yokohama-shi, Kanagawa 222-0033 (JP)
(72) Inventor: Sugaya, Yujiro, Yokohama-shi Kanagawa 222-0033 (JP); Saito, Tomomitsu, Yokohama-shi Kanagawa 222-0033 (JP)
(74) Representative: Müller, Frank

(56) References cited:
- JP-A- 2001 087 877
- JP-A- 2006 140 344
- JP-A- 2006 147 312
- US-B1- 7 462 065

## Description

### BACKGROUND OF THE INVENTION

### FIELD OF THE INVENTION

The present invention relates to a laser welding method which is used, for example, to attach a transient voltage protection element to an electric connector.

### DESCRIPTION OF THE RELATED ART

Generally, as a connector used for an electronic apparatus, and the like, there is known a type that includes a connector body into a predetermined position of which a connection object can be inserted, and a plurality of terminals which are arranged with a space from each other in the connector body in the width direction thereof, and that is configured such that the respective terminals are electrically connected to a connection object inserted into the connector main body by being brought into contact with the connection object.

Further, according to the increase in information transmission amount in recent years, higher speed and integration in various electrical devices have been achieved, and thereby the thickness of insulating walls in electrical components, such as an IC, has been reduced. This results in a problem that the electrical components are destroyed by a transient voltage, such as a voltage due to Electro Static Discharge (ESD). Further, since the number of contacts in a wiring device, such as a connector, has been increased due to the digitization of signals, it is necessary to attach a number of protective devices in order to protect the electrical components from the transient voltage. However, in the present situation, a space on a circuit board in which space the protective devices are mounted is also reduced due to the miniaturization of apparatuses.

Thus, it is effective that the space on the circuit board, in which the protective devices are mounted, is eliminated by attaching a transient voltage protection element to the connector. As the transient voltage protection element, there is known an element which includes a first conductive section connected to a ground terminal, a plurality of second conductive sections respectively connected to a plurality of signal line terminals, and a variable resistance body provided between the first conductive section and each of the second conductive sections, and which is configured such that when a transient voltage is generated in a circuit connected to each of the signal line terminals, the signal line terminal is made conductive to the ground terminal by the variable resistance body so as to allow the transient voltage to be discharged to the outside via the ground terminal (see, for example, Japanese Patent Publication No. 2006-140344).

Meanwhile, in many cases, a number of signal line terminals are arranged in high density due to the miniaturization and the increase in the number of contacts of the connector. This also makes it necessary to form each of the second conductive sections of the transient voltage protection element from a belt-shaped metallic thin plate having a small width. In the case where such narrow belt-shaped metallic thin plate is welded by using, for example, a YAG laser, there is a problem that when the output of the laser is increased in order to surely perform the welding, breakage or damage of the metallic thin plate having the small width is caused by the laser beam, before the metallic thin plate is welded.

Thus, there is known a laser welding method which makes it possible to perform the welding without increasing the output of a laser in such a manner that a laser beam is made incident on one thickness direction surface of a metallic thin plate via a thin film made of a resin having a high absorption rate of the laser beam so that the absorption rate of the laser beam is increased by the thin film (see, for example, Japanese Patent Publication No. 2001-87877).

However, there is a problem that when the laser beam is made incident on the thin film, the resin of the thin film, which resin is carbonized by the heat of the laser beam, is ejected between the metallic thin plates adjacent to each other from between the thin film and the metallic thin plate, so that the insulation resistance between the respective metallic thin plates is lowered by the resin carbide.

### BRIEF SUMMARY OF THE INVENTION

The present invention has been made in view of the above described problems. An object of the present invention is to provide a laser welding method in which when a laser beam is made incident on a thin film, carbide generated by the heat of the laser beam is prevented from being ejected between respective metallic thin plates.

In order to achieve the above described object, according to the present invention, there is provided a laser welding method and a transient voltage protection element as defined in the appended claims 1, 2, and 8, 9 correspondingly.

According to the present invention, when the laser beam is made incident on the thin film, the carbide generated by the heat of the laser beam is prevented from being ejected between the metallic thin plates adjacent to each other. Thus, it is possible to effectively prevent the lowering of the insulation resistance between the respective metallic thin plates due to the carbide.

### BRIEF DESCRIPTION OF SEVERAL VIEWS OF THE DRAWINGS

FIG. 1 is a front view showing a first embodiment of a transient voltage protection element which is attached to a connector by a welding method according to the present invention;
FIG. 2 is a side sectional view of the transient voltage protective element;
FIG. 3 is an exploded perspective view of the transient voltage protection element;
FIG. 4 is a side sectional view of a connector having the transient voltage protection element;
FIG. 5 is a rear view of the connector having the transient voltage protection element;
FIG. 6 is a front side perspective view of the connector showing a mounting process of the transient voltage protection element;
FIG. 7 is a rear side perspective view of the connector showing a mounting process of the transient voltage protection element;
FIG. 8 is a side sectional view of a main portion of the connector showing a welding process according to the present invention;
FIG. 9 is a side sectional view of the main portion of the connector showing a welding process according to the present invention;
FIG. 10 is a side sectional view of a main portion of a connector showing a welding process according to the present invention;
FIG. 11 is a side sectional view of a main portion of a connector showing a welding process according to a second embodiment of the present invention;
FIG. 12 is a side sectional view of the main portion of the connector showing a welding process according to the present invention;
FIG. 13 is a side sectional view of the main portion of the connector showing a welding process according to the present invention;
FIG. 14 is a rear view showing a third embodiment of a transient voltage protection element which is attached to a connector by the welding process according to the present invention;
FIG. 15 is a side sectional view of the transient voltage protection element; and

FIG. 16 is a rear view of a main portion of the transient voltage protection element.

### DETAILED DESCRIPTION OF THE INVENTION

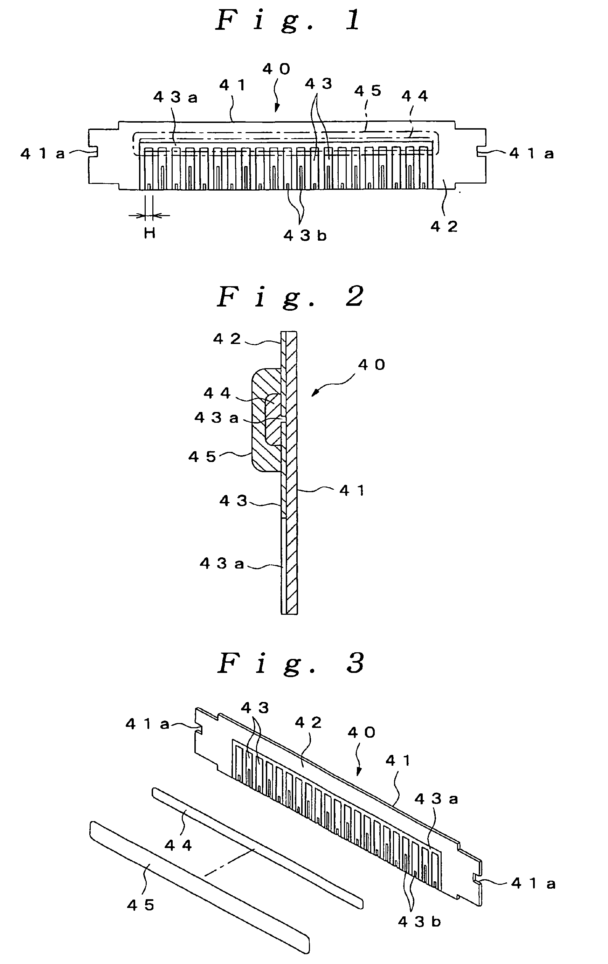

FIG. 1 to FIG. 10 show a first embodiment according to the present invention. A connector shown in the figures is configured by a connector main body 10 into which a mating connector (not shown) as a connection object can be inserted, a plurality of terminals 20 which are arranged in the connector main body 10 at equal intervals from each other in the width direction of the connector main body 10, a holding member 30 which holds the respective terminals 20, and a transient voltage protection element 40 which makes each of the terminals 20 conductive to the connector main body 10 at the time when a transient voltage is generated.

The connector main body 10 is made of a conductive metallic member whose front surface side and rear surface side are opened, respectively. The front opening section of the connector main body 10 forms an insertion opening 10a of the mating connector. A pair of front/rear ground connecting sections 11 which extend downward are integrally provided on each of both the width direction sides of the connector main body 10. Each of the ground connecting sections 11 is connected to the grounding section of a circuit board (not shown). Further, projecting sections 12, which are made to engage with the transient voltage protection element 40, are provided at both width direction ends on the rear surface side of the connector main body 10, respectively.

Each of the terminals 20 is made of a conductive metallic member extended in the front/rear directions. On the front end side of each of the terminals 20, there is formed a contact section 21 which is brought into contact with the terminal of the mating connector. On the rear end side of each of the terminals 20, there are provided a vertical section 22 which is deflected downward, and a board connecting section 23 which is extended from the lower end of the vertical section 22 to the rear side. The board connecting section 23 is configured so as to be connected to a signal line conductive section of a circuit board (not shown).

The holding member 30 is made of an insulating member, such as synthetic resin, and is fixed in the connector main body 10. In the holding member 30, there is provided a terminal supporting section 31 extended forward in a plate shape, and the contact section 21 of each of the terminals 20 is arranged on the lower surface side of the terminal supporting section 31.

The transient voltage protection element 40 is configured by a substrate 41 as a film-like member formed so as to be long in the lateral direction, a first conductive section 42 formed on the front surface of the substrate 41, a plurality of second conductive sections 43 formed on the front surface of the substrate 41, a variable resistance body 44 provided between the first conductive section 42 and the second conductive sections 43, and a covering member 45 configured to cover the variable resistance body 44.

The substrate 41 is made of an organic substance having a high absorption rate of a laser beam (for example, synthetic resin, such as polyimide (PI)), and is formed to have a thickness of 0.1 mm or less. Cut-outs 41A are respectively provided at both the width direction ends of the substrate 41, and are configured so as to engage with the projecting sections 12 of the connector main body 10.

The first conductive section 42 is made of a metallic thin plate which has a thickness of 40 µm or less and which is formed on the one surface of the substrate 41, and is continuously formed so as to extend from both the width direction (long side direction) ends of the substrate 41 to the upper end side over the entire long side direction of the substrate 41.

Similarly to the first conductive section 42, each of the second conductive sections 43 is made of a metallic thin plate which has a thickness of 40 µm or less and which is formed on the one surface of the substrate 41. Further, the second conductive sections 43 are provided on the lower end side of the substrate 41 except the both width direction end sides and the upper end side of the substrate 41, so as to be spaced with each other in the width direction of the substrate 41. Each of the second conductive sections 43 is formed in a belt shape extending in the vertical direction, so as to have a width H of 500 µm or less. A gap 43a of 40 µm or less is formed between the upper end of each of the second conductive sections 43 and the first conductive section 42. The respective gaps 43a are arranged on one straight line along the long side direction of the substrate 41. Further, a slit 43b extended in the vertical direction is provided in each of the second conductive sections 43. The lower end side of each of the slits 43b is formed so as to be opened to the lower end of the second conductive section 43. The respective slits 43b are formed so that the upper end positions of the slits 43b are alternately shifted vertically in the long side direction of the second conductive section 43. The upper end position of each of the slits 43b is set as a welding position as will be described below. That is, the slits 43b, each of which has a longer vertical direction length, and the slits 43b, each of which has a shorter vertical direction length, are alternately provided in the second conductive sections 43. The respective slits 43b are formed by etching together with the first and second conductive sections 42 and 43.

The variable resistance body 44 is formed of a known material using, for example, a nonlinear resistance material, and has a characteristic in which when no transient voltage is generated, it has a high electric resistance, and in which when a transient voltage is generated, it is activated so as to be immediately changed into a material having a low electric resistance. Note that the other material may also be used for the variable resistance body 44 as long as the material has the similar characteristics. The variable resistance body 44 is formed in a straight line shape extended along the long side direction of the substrate 41 so as to cover the gaps 43a of the respective second conductive sections 43, and is filled in each of the gaps 43a as shown in FIG. 2. In this case, the variable resistance body 44 is formed in the straight line shape extended along the long side direction of the substrate 41 in such a manner that a liquid raw material of the variable resistance body 44 is applied or printed on the substrate 41 and cured.

The covering member 45 is made of an insulating member, such as urethane, and is formed in a straight line shape extended along the long side direction of the substrate 41 so as to cover the variable resistance body 44.

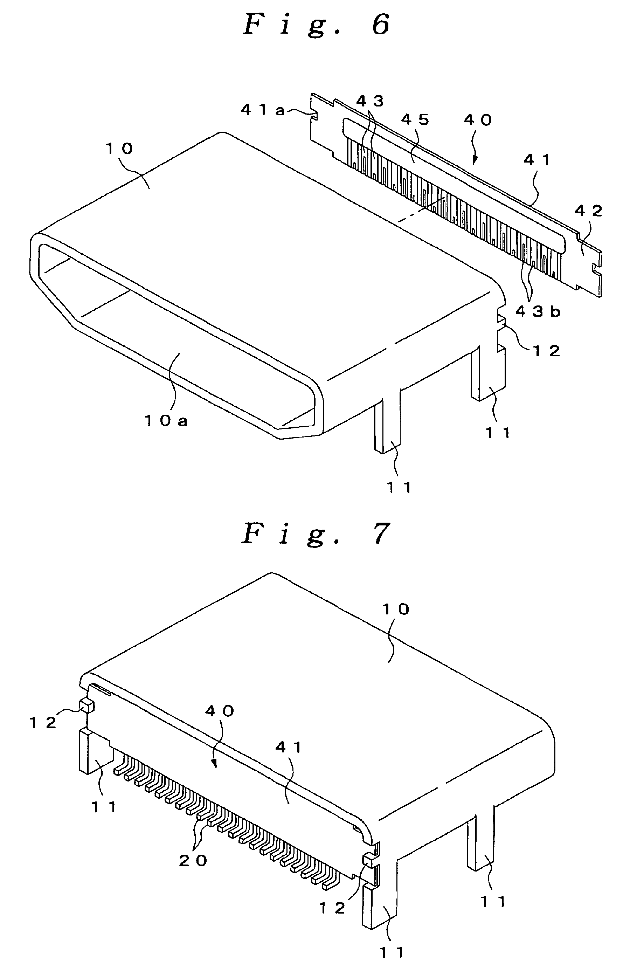

The transient voltage protection element 40 configured as described above is arranged at the rear surface side of the connector main body 10, and is attached to the connector by being joined to the vertical section 22 of each of the terminals 20 and the rear end surface of the connector main body 10 by known YAG laser welding. That is, when the transient voltage protection element 40 is attached, the transient voltage protection element 40 is, as shown in FIG. 6, arranged on the rear surface side of the connector main body 10 so that the substrate 41 is arranged on the rear surface side. Also, as shown in FIG. 7, each of the cut-outs 41a of the substrate 41 is made to engage with each of the projecting sections 12 of the connector main body 10. Thereby, each of the second conductive sections 43 of the transient voltage protection element 40 is arranged so as to correspond to the vertical section 22 of each of the terminals 20.

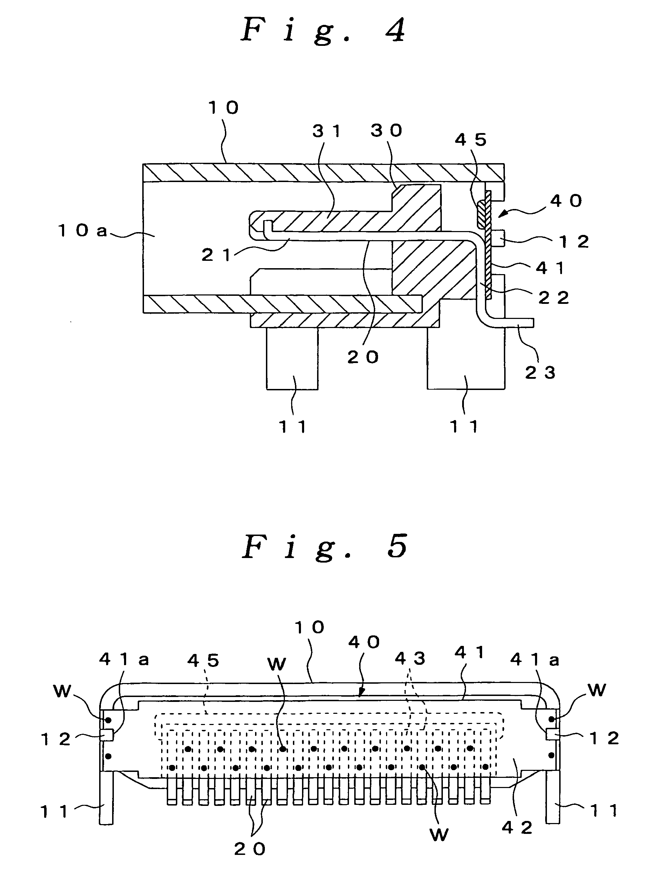

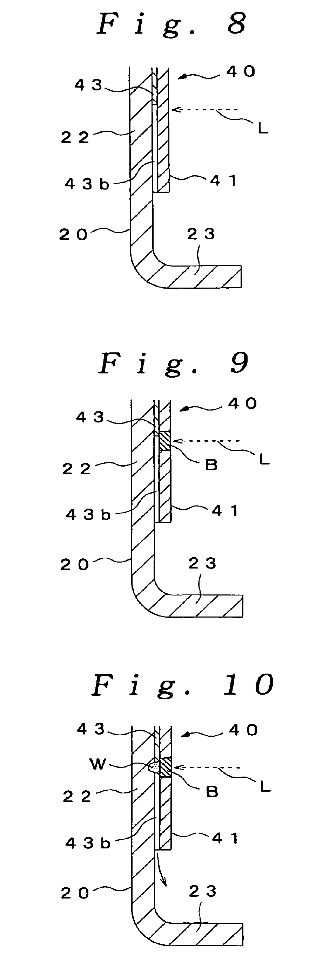

Next, as shown in FIG. 8, a YAG laser beam having a wavelength of 1064 nm is irradiated to the one thickness direction surface (on the rear surface side) of the second conductive section 43 from the side of the substrate 41 at a predetermined pulse width and a predetermined output power. Thereby, the resin at the laser beam incident portion of the substrate 41 is carbonized by the thermal energy of the laser beam, and a black portion B blackened by the carbonization is formed as shown in FIG. 9. In this case, the absorption rate of the laser beam is increased by the black portion B, and thereby the metallic thin plate of the second conductive section 43 is quickly molten by the thermal energy of the laser beam. Then, as shown in FIG. 10, the molten portion penetrates the metallic thin plate of the second conductive section 43 to reach the inside of the terminal 20, so that a welding section W is formed. As a result, the metallic thin plate of the second conductive section 43 is joined, by the welding section W, to the vertical section 22 of the terminal 20 arranged on the other thickness direction surface (on the front surface side) of the second conductive section 43. In this case, as shown in FIG. 5, the second conductive sections 43 are respectively welded to the terminals 20 so that the welding sections W are alternately shifted vertically in the long side direction of the second conductive section 43. Thereby, each of the welding sections W is formed at the upper end position of each of the slits 43b of the second conductive sections 43. In this case, when the resin at the laser beam incident portion is carbonized by the thermal energy of the laser beam, the resin carbide is ejected from the welded portion. However, as shown by the solid line arrow in FIG. 10, the carbide is discharged to the outside of the substrate 41 from the lower end of the second conductive section 43 via the slit 43b, so that the carbide is prevented from being ejected between the second conductive sections 43 adjacent to each other. Further, the laser beam is irradiated from the side of the substrate 41 to the one thickness direction surface (on the rear surface side) of the first conductive section 42, which surface corresponds to both the width direction sides of the connector main body 10. Thereby, the first conductive section 42 is welded to the rear end surface of the connector main body 10 in a similar manner as described above.

In the connector to which the transient voltage protection element 40 is attached, when the board connecting section 23 of each of the terminals 20 and each of the ground connecting sections 11 are soldered to a circuit board (not shown), the respective terminals 20 are connected to the circuit pattern of the circuit board, and the respective ground connecting sections 11 are connected to the grounding section of the circuit board. Further, when the mating connector (not shown) is inserted into the insertion opening 10a of the connector main body 10, the contact section 21 of each of the terminals 20 is brought into contact with each terminal of the mating connector, so that the electrical connection with the mating connector is effected.

Here, when a transient voltage is generated due to static electricity, or the like, on the side of the mating connector, the terminal 20 of the signal line on which the transient voltage is generated is made conductive to the connector main body 10 by the transient voltage protection element 40. Thereby, the circuit on the side of the circuit board is protected from the transient voltage. That is, when a transient voltage is generated on any one of the signal lines of the mating connector, the variable resistance body 44 is immediately changed to a low electric resistance material. Thereby, the terminal 20 is made conductive to the connector main body 10 via the variable resistance body 44, so that the transient voltage is discharged to the ground side of the circuit board via each of the ground connecting sections 11 of the connector main body 10. In this case, the characteristics of the variable resistance body 44 depend on the size of the gap 43a.

In this way, the present embodiment is configured such that the slit 43b is provided in each of the second conductive sections 43 made of the metallic thin plate so as to extend from the welding position to the end of the second conductive section 43, and that the second conductive sections 43 are respectively welded to the terminals 20 by making the laser beam incident on the welding positions of the substrate 41 (thin film). Thus, even when the resin at the laser beam incident portion is carbonized by the thermal energy of the laser beam and thereby the resin carbide is ejected from the welding portion, it is possible to discharge the carbide to the outside from the lower end of the second conductive section 43 via the slit 43b of the second conductive section 43. Thereby, the carbide is prevented from being ejected between the second conductive sections 43 adjacent to each other, and hence it is possible to effectively prevent the lowering of the insulation resistance between the respective second conductive sections 43 due to the carbide.

In this case, it is configured such that the laser beam is made incident on the second conductive section 43 via the substrate 41 which is made of an organic material having a high absorption rate of the laser beam and which has a thickness of 0.1 mm or less. Thereby, the absorption rate of the laser beam is increased by the substrate 41, so that, for example, even when the YAG laser having the wavelength of 1064 nm is used, the welding can be surely performed without increasing the output of the laser. Thereby, even a metallic thin plate having a small width, such as the second conductive section 43, can be welded without being broken. This is particularly advantageous in the case where the transient voltage protection element 40 for a small connector in which respective terminals 20 are densely arranged is attached to the connector.

Further, it is configured such that the substrate 41 made of an organic material is blackened by being carbonized by the laser beam and thereby the absorption rate of the laser beam in the substrate 41 is increased. Thus, processing to increase the absorption rate need not be separately performed, and hence it is possible to improve the productivity.

Further, when the second conductive section 43 is formed to have a thickness of 40 µm or less and a width of 500 µm or less, the metallic thin plate is easily broken by a usual welding method using the YAG laser having the wavelength of 1064 nm. Thus, the welding method according to the present embodiment is particularly advantageous in the case where the metallic thin plate having such dimensions is welded.

Further, it is configured such that the second conductive section 43 as a metallic thin plate is formed integrally with the substrate 41 as a film-like member, so as to be welded by making the laser beam incident from the side of the substrate 41. Thereby, the absorption rate of the laser beam can be increased by the substrate 41 for holding the respective second conductive sections 43, which results in the advantage that the film-like member needs not be added other than the substrate 41.

Further, it is configured such that the plurality of second conductive sections 43 are arranged on the substrate 41 in the width direction, and that a part of the respective welding positions are shifted from the other part of the welding positions in the long side direction of the second conductive section 43. Thus, even when the respective second conductive sections 43 are arranged close to each other in the width direction, the interval between the respective welding sections W can be increased, so that the welding can be easily performed even in the case where the respective second conductive sections 43 are densely arranged. In this case, the welding positions are alternately shifted in the long side direction of the second conductive section 43. Thus, even when a slight amount of the carbide is ejected between the second conductive sections 43 adjacent to each other, the carbide is prevented from being ejected at the same position from the second conductive sections 43 adjacent to each other. This is particularly advantageous to prevent the lowering of the insulation resistance due to the carbide. Further, the welding positions are alternately shifted in the long side direction of the respective second conductive sections 43, which is effective to prevent the exfoliation of the substrate 41 as compared with the case where the welding positions are arranged in a row.

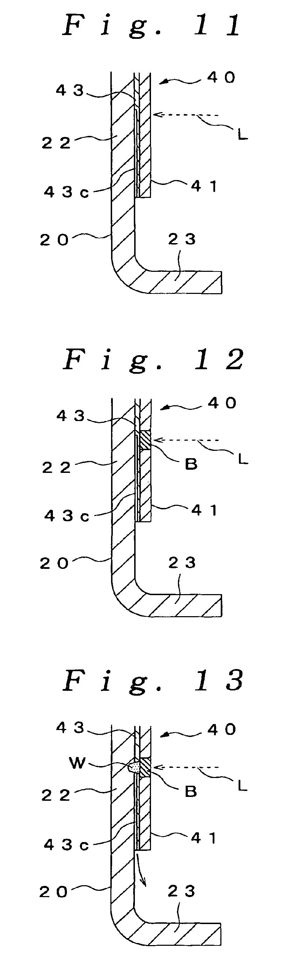

FIG. 11 to FIG. 13 show a second embodiment according to the present invention, and the same components as those in the first embodiment are denoted by the same reference numerals and characters.

In the first embodiment, there is shown a configuration in which the slit 43b that penetrates the second conductive section 43 made of a metallic thin plate in the thickness direction thereof is provided in the second conductive section 43. However, in the present embodiment, instead of the slit 43b in the first embodiment, in one surface of each of the second conductive sections 43, a groove 43c, which does not penetrate the second conductive section 43 in the thickness direction thereof, is provided so as to extend from the welding position to the end of the second conductive section 43.

Thereby, the carbide ejected from the welding portion can be discharged to the outside from the lower end of the second conductive section 43 via the groove 43c. Thus, similarly to the first embodiment, the carbide is prevented from being ejected between the second conductive sections 43 adjacent to each other. Thereby, it is possible to effectively prevent the lowering of the insulation resistance between the respective second conductive sections 43 due to the carbide.

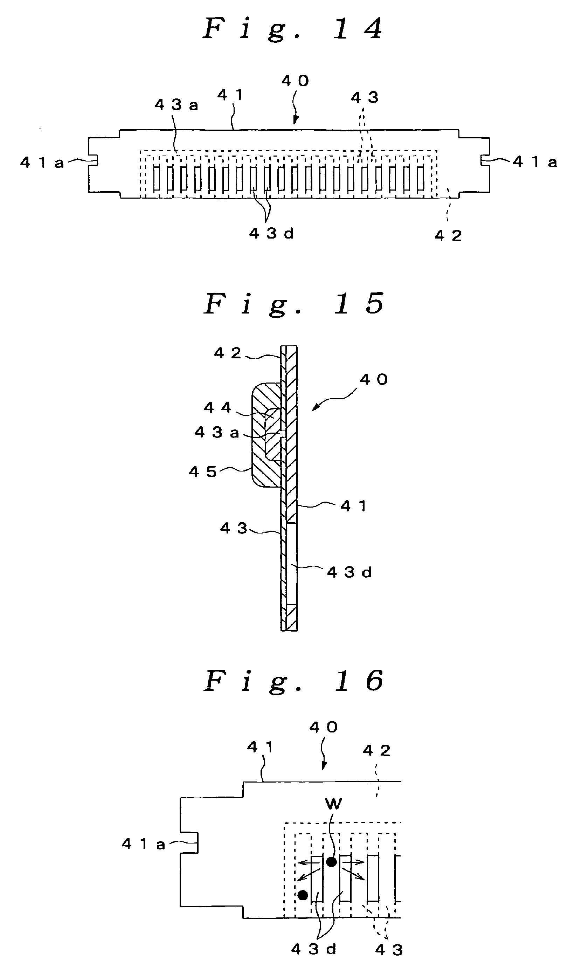

FIG. 14 to FIG. 16 show a third embodiment according to the present invention, and the same components as those in the first embodiment are denoted by the same reference numerals and characters.

In the present embodiment, instead of the slit 43b in the first embodiment, a vertically slit 43d which penetrates the substrate 41 in the thickness direction thereof is provided between the welding positions of the substrate 41 (thin film) so that the second conductive sections 43 are respectively welded to the terminals 20 by making the laser beam incident at the respective welding positions of the substrate 41.

Thereby, as shown by the solid line arrow in FIG. 16, the carbide ejected from between the substrate 41 and the second conductive sections 43 at the welding position can be discharged to the outside from the hole 43d of the substrate 41. Thus, similarly to the first embodiment, the carbide is prevented from being ejected between the second conductive sections 43 adjacent to each other. Thereby, it is possible to effectively prevent the lowering of the insulation resistance between the respective second conductive sections 43 due to the carbide.

Note that in each of the above described embodiments, there is shown the connector which is connected to a mating connector, but the connecter may also be a connector for connecting, for example, a flexible printed circuit (FPC), a flexible flat cable (FFC), and the like.

Further, in each of the above described embodiments, there is shown the welding method for attaching the transient voltage protection element 40 to the connector, but the present invention can be used for various kinds of welding in other uses, as long as the welding is used to weld a metallic thin plate. In this case, the thin film may also be formed by applying a black paint to a welding portion of the metallic thin plate without using the substrate 41 as a film-like member as used in the above described embodiments.

## Claims

1. A laser welding method, comprising the following steps:
- arranging a plurality of belt-shaped metallic thin plates (43) with a space from each other in the width direction of the metallic thin plates (43), wherein in each of the metallic thin plates (43), a slit (43b) or a groove (43c) which extends from a welding position to the end of the metallic thin plate (43) is provided,
- forming a thin film (41) made of an organic material having a high absorption rate to a laser beam on one thickness direction surface of the metallic thin plate (43),
- arranging a welding object (20) on the side of the other thickness direction surface of the metallic thin plate (43),
- making the laser beam incident from the one thickness direction surface via the thin film (41) so as to thereby weld the welding object (20) to the metallic thin plate (43), such that the metallic thin plate (43) and the welding object (20) are welded to each other by making the laser beam incident at the welding position of the thin film (41).

2. A laser welding method, comprising the following steps:
- arranging a plurality of belt-shaped metallic thin plates (43) with a space from each other in the width direction of the metallic thin plates (43),
- forming a thin film (41) made of an organic material having a high absorption rate to a laser beam on one thickness direction surface of the metallic thin plate (43), wherein a hole (43d) penetrating the thin film (41) in the thickness direction thereof is provided between respective welding positions of the thin film (41),
- arranging a welding object (20) on the side of the other thickness direction surface of the metallic thin plate (43),
- making the laser beam incident from the one thickness direction surface via the thin film (41) so as to thereby weld the welding object (20) to the metallic thin plate (43), such that the metallic thin plate (43) and the welding object (20) are welded to each other by making the laser beam incident at the welding position of the thin film (41).

3. The laser welding method according to one of claim 1 and claim 2, wherein a flm-like member having a thickness of 0.1 mm or less is used as the thin film (41).

4. The laser welding method according to one of claim 1 and claim 2, wherein the laser beam absorption rate of the thin film (41) is increased in such a manner that the thin film (41) is blackened by being carbonized by the laser beam.

5. The laser welding method according to one of claim 1 and claim 2, wherein the metallic thin plate (43) is formed to have a thickness of 40 [micro]m or less and a width of 500 [micro]m or less.

6. The laser welding method according to one of claim 1 and claim 2, wherein the thin film (41) is integrally formed on one thickness direction surface of the metallic thin plate (43), and wherein the metallic thin plate (43) is welded to the welding object (20) by making the laser beam incident at the welding position of the thin film (41).

7. The laser welding method according to claim 6, wherein the welding is performed in such a manner that a part of the respective welding positions are shifted from the other part of the welding positions in the long side direction of the metallic thin plate (43).

8. Transient voltage protection element (40), comprising a plurality of belt-shaped metallic thin plates (43) arranged with a space from each other in the width direction of the metallic thin plates (43),
a thin film (41) made of an organic material having a high absorption rate to a laser beam on one thickness direction surface of the metallic thin plates (43),
and a welding object (20) arranged on the side of the other thickness direction surface of the metallic thin plates (43),
wherein in each of the metallic thin plates (43), a slit (43b) or a groove (43c) which extends from a welding position to the end of the metallic thin plate (43) is provided,
and wherein the metallic thin plate (43) and the welding object (20) are welded to each other by making a laser beam incident on one thickness direction surface of the metallic thin plates (43) via the thin film (41) at a welding position of the thin film (41).

9. Transient voltage protection element (40), comprising a plurality of belt-shaped metallic thin plates (43) arranged with a space from each other in the width direction of the metallic thin plates (43),
a thin film (41) made of an organic material having a high absorption rate to a laser beam on one thickness direction surface of the metallic thin plates (43),
and a welding object (20) arranged on the side of the other thickness direction surface of the metallic thin plates (43),
wherein a hole (43d) penetrating the thin film (41) in the thickness direction thereof is provided between respective welding positions of the thin film (41),
and wherein the metallic thin plate (43) and the welding object (20) are welded to each other by making a laser beam incident on one thickness direction surface of the metallic thin plates (43) via the thin film (41) at a welding position of the thin film (41).

10. Transient voltage protection element (40) according to one of claim 8 and claim 9, wherein a film-like member having a thickness of 0.1 mm or less is used as the thin film. (41).

11. Transient voltage protection element (40) according to one of claim 8 and claim 9, wherein the laser beam absorption rate of the thin film (41) is increased in such a manner that the thin film (41) is blackened by being carbonized by the laser beam.

12. Transient voltage protection element (40) according to one of claim 8 and claim 9, wherein the metallic thin plate (43) is formed to have a thickness of 40 [micro]m or less and a width of 500 [micro]m or less.

13. Transient voltage protection element (40) according to one of claim 8 and claim 9, wherein the thin film (41) is integrally formed on one thickness direction surface of the metallic thin plate (43), and wherein the metallic thin plate (43) is welded to the welding object (20) by making the laser beam incident at the welding position of the thin film (41).

14. Transient voltage protection element (40) according to claim 13, wherein the welding is performed in such a manner that a part of the respective welding positions are shifted from the other part of the welding positions in the long side direction of the metallic thin plate (43).

## Patentansprüche

1. Laserschweißverfahren, umfassend die folgenden Schritte:
- Anordnen einer Mehrzahl bandförmiger metallischer dünner Platten (43) in einem Abstand voneinander in der Breitenrichtung der metallischen dünnen Platten (43), wobei in jeder der metallischen dünnen Platten (43) ein Schlitz (43b) oder eine Nut (43c) vorhanden ist, die sich von einer Schweißposition zum Ende der metallischen dünnen Platte (43) erstreckt,
- Bilden einer dünnen Schicht (41) aus einem organischen Material mit einer hohen Absorptionsrate gegenüber einem Laserstrahl auf einer Oberfläche in der Dickenrichtung der metallischen dünnen Platte (43),
- Anordnen eines Schweißobjekts (20) auf der Oberflächenseite der metallischen dünnen Platte (43) in der gegenüberliegenden Dickenrichtung,
- Richten eines Laserstrahls aus der einen Dickenrichtung auf die Oberfläche über die dünne Schicht (41), derart, dass das Schweißobjekt (20) auf die metallische dünne Platte (43) geschweißt wird, so dass die metallische dünne Platte (43) und das Schweißobjekt (20) durch das Richten des Laserstrahls auf die Schweißposition der dünnen Schicht (41) miteinander verschweißt werden.

2. Laserschweißverfahren, umfassend die folgenden Schritte:
- Anordnen einer Mehrzahl bandförmiger metallischer dünner Platten (43) in einem Abstand voneinander in der Breitenrichtung der metallischen dünnen Platten (43),
- Bilden einer dünnen Schicht (41) aus einem organischen Material mit einer hohen Absorptionsrate gegenüber einem Laserstrahl auf einer Oberfläche in einer Dickenrichtung der metallischen dünnen Platte (43), wobei ein Loch (43b), dass die dünne Schicht (41) in deren Dickenrichtung durchdringt, zwischen jeweiligen Schweißpositionen der dünnen Schicht (41) vorhanden ist,
- Anordnung eines Schweißobjekts (20) auf der Seite der gegenüberliegenden Dickenrichtungsoberfläche der metallischen dünnen Platte (43),
- Richten des Laserstrahls, der von der einen Dickenrichtung her einfällt, auf die Oberfläche über die dünne Schicht (41), so dass das Schweißobjekt (20) mit der metallischen dünnen Platte (43) verschweißt wird, derart, dass die metallische dünne Platte (43) und das Schweißobjekt (20) durch Richten des Laserstrahls auf die Schweißposition der dünnen Schicht (41) miteinander verschweißt werden.

3. Laserschweißverfahren gemäß Anspruch 1 oder 2, bei welchem ein schichtartiges Element mit einer Dicke von 0,1 mm oder weniger als dünne Schicht (41) verwendet wird.

4. Laserschweißverfahren gemäß einem der Ansprüche 1 oder 2, bei welchem die Laserstrahl-Absorptionsrate der dünnen Schicht (41) auf solche Weise erhöht ist, dass die dünne Schicht (41) geschwärzt ist, indem sie durch den Laserstrahl verkohlt wird.

5. Laserschweißverfahren gemäß einem der Ansprüche 1 oder 2, bei welchem die metallische dünne Platte (43) so ausgebildet ist, dass sie eine Dicke von 40 Mikrometern oder weniger und eine Breite von 500 Mikrometern oder weniger aufweist.

6. Laserschweißverfahren gemäß einem der Ansprüche 1 oder 2, bei welchem die dünne Schicht (41) einstückig mit der Oberfläche auf einer Dickenrichtung der metallischen dünnen Platte (43) ausgebildet ist, wobei die metallische dünne Platte (43) mit dem Schweißobjekt (20) verschweißt wird, indem der Laserstrahl auf die Schweißposition der dünnen Schicht (41) gerichtet wird.

7. Laserschweißverfahren gemäß Anspruch 6, bei welchem das Schweißen derart durchgeführt wird, dass ein Teil der jeweiligen Schweißpositionen gegenüber dem anderen Teil der Schweißpositionen entlang der Längenrichtung der metallischen dünnen Platte (43) verschoben ist.

8. Überspannungsschutzelement (40), umfassend eine Mehrzahl bandförmiger metallischer dünner Platten (43), die voneinander in der Breitenrichtung der metallischen dünnen Platten (43) beabstandet angeordnet sind,
eine dünne Schicht (41) aus einem organischen Material mit einer hohen Absorptionsrate gegenüber einem Laserstrahl auf einer Oberfläche in einer Dickenrichtung der metallischen dünnen Platten (43),
und ein Schweißobjekt (20), das auf der Seite der Oberfläche der gegenüberliegenden Dickenrichtung der metallischen dünnen Platten (43) angeordnet ist,
wobei in jeder der metallischen dünnen Platten (43) ein Schlitz (43b) oder eine Nut (43c) vorhanden ist, die sich von einer Schweißposition zum Ende der metallischen dünnen Platte (43) erstreckt,
und wobei die metallische dünne Platte (43) und das Schweißobjekt (20) miteinander verschweißt sind, indem ein Laserstrahl aus einer Dickenrichtung auf die entsprechende Oberfläche der metallischen dünnen Platten (43) über die dünne Schicht (43) an einer Schweißposition der dünnen Schicht (41) gerichtet wird.

9. Überspannungsschutzelement (40), umfassend eine Mehrzahl bandförmiger metallischer dünner Platten (43), die voneinander beabstandet in der Breitenrichtung der metallischen dünnen Platten (43) angeordnet sind,
eine dünne Schicht (41) aus einem organischen Material mit einer hohen Absorptionsrate gegenüber einem Laserstrahl auf einer Oberfläche in einer Dickenrichtung der metallischen dünnen Platten (43),
und ein Schweißobjekt (20), dass auf der Seite der Oberfläche der gegenüberliegenden Dickenrichtung der metallischen dünnen Platten (43) angeordnet ist,
wobei ein Loch (43d), das die dünne Schicht (41) in deren Dickenrichtung durchdringt, zwischen jeweiligen Schweißpositionen auf der dünnen Schicht (41) angeordnet ist,
und wobei die metallische dünne Platte (43) und das Schweißobjekt (20) miteinander verschweißt werden, indem ein Laserstrahl auf die Oberfläche in einer Dickenrichtung der metallischen dünnen Platten (43) über die dünne Schicht (41) an einer Schweißposition der dünnen Schicht (41) gerichtet wird.

10. Überspannungsschutzelement (40) gemäß einem der Ansprüche 8 oder 9, bei welchem ein schichtartiges Element mit einer Dicke von 0,1 mm oder weniger als die dünne Schicht (41) verwendet wird.

11. Überspannungsschutzelement (40) gemäß einem der Ansprüche 8 oder 9, bei welchem die Laserstrahl-Absorptionsrate der dünnen Schicht (41) auf solche Weise erhöht ist, dass die dünne Schicht (41) geschwärzt wird, indem sie durch den Laserstrahl verkohlt wird.

12. Überspannungsschutzelement (40) gemäß einem der Ansprüche 8 oder 9, bei welchem die metallische dünne Platte (43) derart ausgebildet ist, dass sie eine Dicke von 40 Mikrometer oder weniger und eine Breite von 500 Mikrometer oder weniger aufweist.

13. Überspannungsschutzelement (40) gemäß einem der Ansprüche 8 oder 9, bei welchem die dünne Schicht (41) einstückig auf einer Oberfläche in einer Dickenrichtung der metallischen dünnen Platte (41) ausgebildet ist, wobei die metallische dünne Platte (43) mit dem Schweißobjekt (20) durch Richten des Laserstrahls auf die Schweißposition der dünnen Schicht (41) verschweißt wird.

14. Überspannungsschutzelement (40) gemäß Anspruch 13, bei welchem das Schweißen auf solche Weise durchgeführt wird, dass ein Teil der jeweiligen Schweißpositionen gegenüber dem verbleibenden Teil der Schweißpositionen in der Längsrichtung der metallischen dünnen Platte (43) verschoben wird.

## Revendications

1. Procédé de soudage au laser comportant les étapes suivantes consistant à :
- disposer une pluralité de plaques métalliques minces en forme de ceinture (43) avec un espace entre elles dans la direction de largeur des plaques métalliques minces (43), dans lequel dans chacune des plaques métalliques minces (43), une fente (43b) ou une rainure (43c) qui s'étend depuis une position de soudage jusqu'à l'extrémité de la plaque métallique mince (43) est prévue,
- former un film mince (41) constitué d'un matériau organique ayant un taux d'absorption élevé pour un faisceau laser sur une surface de direction d'épaisseur de la plaque métallique mince (43),
- disposer un objet de soudage (20) sur le côté de l'autre surface de direction d'épaisseur de la plaque métallique mince (43),
- rendre le faisceau laser incident depuis la surface de direction d'épaisseur via le film mince (41) de manière à souder ainsi l'objet de soudage (20) à la plaque métallique mince (43), de sorte que la plaque métalliques mince (43) et l'objet de soudage (20) sont soudés entre eux en rendant le faisceau laser incident au niveau de la position de soudage du film mince (41).

2. Procédé de soudage au laser, comportant les étapes suivantes consistant à :
- disposer une pluralité de plaques métalliques minces en forme de ceinture (43) avec un espace entre elles dans la direction de largeur des plaques métalliques minces (43),
- former un film mince (41) constitué d'un matériau organique ayant un taux d'absorption élevé pour un faisceau laser sur une surface de direction d'épaisseur de la plaque métallique mince (43), dans lequel un trou (43d) pénétrant le film mince (41) dans la direction d'épaisseur de celui-ci est prévu entre des positions de soudage respectives du film mince (41),
- disposer un objet de soudage (20) sur le côté de l'autre surface de direction d'épaisseur de la plaque métallique mince (43),
- rendre le faisceau laser incident depuis la surface de direction d'épaisseur via le film mince (41) de manière à souder ainsi l'objet de soudage (20) à la plaque métallique mince (43), de sorte que la plaque métallique mince (43) et l'objet de soudage (20) sont soudés entre eux en rendant le faisceau laser incident au niveau de la position de soudage du film mince (41).

3. Procédé de soudage au laser selon l'une de la revendication 1 et de la revendication 2, dans lequel un élément de type film ayant une épaisseur de 0,1 mm ou moins est utilisé en tant que film mince (41).

4. Procédé de soudage laser selon l'une de la revendication 1 et de la revendication 2, dans lequel le taux d'absorption de faisceau laser du film mince (41) augmente de manière à que le film mince (41) soit noirci en étant carbonisé par le faisceau laser.

5. Procédé de soudage au laser selon l'une de la revendication 1 et de la revendication 2, dans lequel la plaque métallique mince (43) est formée pour avoir une épaisseur de 40 [micro]m ou moins et une largeur de 500 [micro]m ou moins.

6. Procédé de soudage au laser selon l'une de la revendication 1 et de la revendication 2, dans lequel le film mince (41) est intégralement formé sur une surface de direction d'épaisseur de la plaque métallique mince (43), et dans lequel la plaque métallique mince (43) est soudée à l'objet de soudage (20) en rendant le faisceau laser incident au niveau de la position de soudage du film mince (41).

7. Procédé de soudage laser selon la revendication 6, dans lequel le soudage est exécuté de sorte qu'une partie des positions de soudage respectives est décalée par rapport à l'autre partie des positions de soudage dans la direction de côté long de la plaque métallique mince (43).

8. Élément de protection contre une tension transitoire (40), comportant une pluralité de plaques métalliques minces en forme de ceinture (43) disposées avec un espace entre elles dans la direction de largeur des plaques métalliques minces (43),
un film mince (41) constitué d'un matériau organique ayant un taux d'absorption élevé pour à un faisceau laser sur une surface de direction d'épaisseur des plaques métalliques minces (43),
et un objet de soudage (20) disposé sur le côté de l'autre surface de direction d'épaisseur des plaques métalliques minces (43),
dans lequel dans chacune des plaques métalliques minces (43), une fente (43b) ou une rainure (43c) qui s'étend depuis une position de soudage jusqu'à l'extrémité de la plaque métallique mince (43) est prévue,
et dans lequel la plaque métallique mince (43) et l'objet de soudage (20) sont soudés ensemble en rendant un faisceau laser incident sur une surface de direction d'épaisseur des plaques métalliques minces (43) via le film mince (41) au niveau d'une position de soudage du film mince (41).

9. Élément de protection contre une tension transitoire (40), comportant une pluralité de plaques métalliques minces en forme de ceinture (43) disposées avec un espace entre elles dans la direction de largeur des plaques métalliques minces (43),
un film mince (41) constitué d'un matériau organique ayant un taux d'absorption élevé pour un faisceau laser sur une surface de direction d'épaisseur des plaques métalliques minces (43),
et un objet de soudage (20) disposé sur le côté de l'autre surface de direction d'épaisseur des plaques métalliques minces (43),
dans lequel un trou (43d) pénétrant le film mince (41) dans la direction d'épaisseur de celui-ci est prévu entre des positions de soudage respectives du film mince (41),
et dans lequel la plaque métallique mince (43) et l'objet de soudage (20) sont soudés ensemble en rendant un faisceau laser incident sur une surface de direction d'épaisseur des plaques métalliques minces (43) via le film mince (41) au niveau d'une position de soudage du film mince (41).

10. Élément de protection contre une tension transitoire (40) selon l'une de la revendication 8 et de la revendication 9, dans lequel un élément de type film ayant une épaisseur de 0,1 mm ou moins est utilisé en tant que film mince (41).

11. Élément de protection contre une tension transitoire (40) selon l'une de la revendication 8 et de la revendication 9, dans lequel le taux d'absorption de faisceau laser du film mince (41) augmente de manière à ce que le film mince (41) soit noirci en étant carbonisé par le faisceau laser.

12. Élément de protection contre une tension transitoire (40) selon l'une de la revendication 8 et de la revendication 9, dans lequel la plaque métallique mince (43) est formée pour avoir une épaisseur de 40 [micro]m ou moins et une largeur de 500 [micro]m ou moins.

13. Élément de protection contre une tension transitoire (40) selon l'une de la revendication 8 et de la revendication 9, dans lequel le film mince (41) est intégralement formé sur une surface de direction d'épaisseur de la plaque métallique mince (43), et dans lequel la plaque métallique mince (43) est soudée à l'objet de soudage (20) en rendant le faisceau laser incident au niveau de la position de soudage du film mince (41).

14. Élément de protection contre une tension transitoire (40) selon la revendication 13, dans lequel le soudage est exécuté de sorte qu'une partie des positions de soudage respectives est décalée par rapport à l'autre partie des positions de soudage dans la direction de côté long de la plaque métallique mince (43).
